# EUROPEAN PATENT APPLICATION

(11) **EP 4 607 599 A1**
(43) Date of publication of application: **27.08.2025**
(21) Application number: 23888478.7
(22) Date of filing: 23.10.2023
(51) Int. Cl.: H01L 33/22, H01L 33/56

(54) **SEMICONDUCTOR LIGHT-EMITTING ELEMENT, SEMICONDUCTOR LIGHT-EMITTING ELEMENT PRODUCTION METHOD, LIGHT-EMITTING MODULE, AND LIGHT-EMITTING MODULE PRODUCTION METHOD**

(30) Priority: 10.11.2022 JP 2022180384
(71) Applicant: National Institute of Information and Communications Technology, Koganei-shi, Tokyo 184-8795 (JP)
(72) Inventor: INOUE, Shinichiro, Koganei-shi, Tokyo 184-8795 (JP)
(74) Representative: Prüfer & Partner mbB Patentanwälte · Rechtsanwälte
(86) International application number: PCT/JP2023/038164
(87) International publication number: WO 2024/101127

(57) **Abstract**

A semiconductor light-emitting element (100, 200, 300) includes a substrate (10) and a semiconductor layer (20). A constituent material of the substrate is single-crystalline aluminum nitride. The substrate has a first main surface (10a) and a second main surface (10b) opposite to the first main surface. The semiconductor layer includes: an n-type semiconductor layer (21) disposed on the first main surface; an active layer (22) disposed on the n-type semiconductor layer to generate deep ultraviolet light; and a p-type semiconductor layer (23) disposed on the active layer. The semiconductor layer has a plurality of mesa structures (24) in one of cross-sectional views. A plurality of protrusions (10c) are formed on the second main surface. Each of the protrusions faces each of the mesa structures. Each of the protrusions has a top surface (10d). An angle (θ1) defined by tan⁻¹{(W2-W1)/2L} is -25° or more and 65° or less.

## Description

### TECHNICAL FIELD

The present disclosure relates to a semiconductor light-emitting element, a method of manufacturing the semiconductor light-emitting element, a light-emitting module, and a method of manufacturing the light-emitting module.

### BACKGROUND ART

NPL 1 (M. Khizar et al., "Nitride deep-ultraviolet light-emitting diodes with microlens array", Applied Physics Letters, 86, 173504, April 18, 2005) discloses a semiconductor light-emitting element. The semiconductor light-emitting element disclosed in NPL 1 includes a substrate and a semiconductor layer. The substrate has a first main surface and a second main surface opposite to the first main surface. The constituent material of the substrate is sapphire. The semiconductor layer is disposed on the first main surface and includes an active layer that generates deep ultraviolet light. The semiconductor layer has a mesa structure. The second main surface is provided with a plurality of microlenses.

PTL 1 (Japanese Patent Laying-Open No. 2017-17110) discloses a semiconductor light-emitting element. The semiconductor light-emitting element disclosed in PTL 1 includes a substrate and a semiconductor layer. The substrate has: a first main surface; a second main surface opposite to the first main surface; and an outer peripheral side surface inclined with respect to the first main surface and the second main surface. The constituent material of the substrate is aluminum nitride. The semiconductor layer is disposed on the first main surface and includes an active layer that generates deep ultraviolet light. The semiconductor layer has a mesa structure.

### CITATION LIST

### PATENT LITERATURE

PTL 1: Japanese Patent Laying-Open No. 2017-17110

### NON PATENT LITERATURE

NPL 1: M. Khizar et al., "Nitride deep-ultraviolet light-emitting diodes with microlens array", Applied Physics Letters, 86, 173504 (April 18, 2005)

### SUMMARY OF INVENTION

### TECHNICAL PROBLEM

For each of the semiconductor light-emitting elements disclosed in NPL 1 and PTL 1, there is still room for improvement in extraction efficiency for deep ultraviolet light.

More specifically, in the semiconductor light-emitting element disclosed in NPL 1, one microlens does not correspond to one mesa structure. In the semiconductor light-emitting element disclosed in NPL 1, a plurality of microlenses are formed by dry etching the second main surface. It is, however, difficult to deeply etch the substrate by dry etching, and the substrate between two adjacent microlenses becomes thicker. In the semiconductor light-emitting element disclosed in NPL 1, this results in a longer distance through which the deep ultraviolet light generated in the active layer passes through the substrate before this deep ultraviolet light is extracted from the second main surface. Thus, when the substrate is formed of aluminum nitride having a large absorption coefficient with respect to the deep ultraviolet light, the extraction efficiency for the deep ultraviolet light decreases.

Also in the semiconductor light-emitting element disclosed in PTL 1, the deep ultraviolet light generated in the active layer passes through the substrate for a long distance before it is extracted from the outer peripheral side surface, with the result that the extraction efficiency for deep ultraviolet light similarly decreases.

The present disclosure has been made in view of the problems in the prior art as described above. More specifically, the present disclosure provides a semiconductor light-emitting element that enables improvement in extraction efficiency for deep ultraviolet light.

### SOLUTION TO PROBLEM

A semiconductor light-emitting element of the present disclosure includes a substrate and a semiconductor layer. A constituent material of the substrate is single-crystalline aluminum nitride. The substrate has a first main surface and a second main surface opposite to the first main surface. The semiconductor layer has: an n-type semiconductor layer disposed on the first main surface; an active layer disposed on the n-type semiconductor layer to generate deep ultraviolet light; and a p-type semiconductor layer disposed on the active layer. The semiconductor layer has a plurality of mesa structures in one of cross-sectional views. A plurality of protrusions are formed on the second main surface. Each of the protrusions faces each of the mesa structures. Each of the protrusions has a top surface. An angle defined by tan⁻¹{(W2-W1)/2L} is -25° or more and 65° or less, where W1 is a width of each of the mesa structures, W2 is a width of the top surface, and L is a distance between the active layer and the top surface.

### ADVANTAGEOUS EFFECTS OF INVENTION

According to the semiconductor light-emitting element of the present disclosure, the extraction efficiency for deep ultraviolet light can be improved.

### BRIEF DESCRIPTION OF DRAWINGS

Fig. 1 is a plan view of a semiconductor light-emitting element 100.
Fig. 2 is a plan view of semiconductor light-emitting element 100 as viewed from a side opposite to that shown in Fig. 1.
Fig. 3A is a cross-sectional view taken along III-III in Fig. 1.
Fig. 3B is an example of a cross-sectional SEM photograph in semiconductor light-emitting element 100.
Fig. 4 is a cross-sectional view of a semiconductor light-emitting element 100 according to a modification.
Fig. 5 is a diagram of a process for manufacturing semiconductor light-emitting element 100.
Fig. 6 is a cross-sectional view illustrating a preparing step S1.
Fig. 7 is a cross-sectional view illustrating a semiconductor layer forming step S2.
Fig. 8 is a cross-sectional view illustrating a mesa structure forming step S3.
Fig. 9 is a cross-sectional view illustrating a first electrode forming step S4.
Fig. 10 is a cross-sectional view illustrating a second electrode forming step S5.
Fig. 11 is a cross-sectional view illustrating a substrate back surface processing step S6.
Fig. 12 is a cross-sectional view illustrating a mask forming step S7.
Fig. 13A is a graph showing a relation between a current and an optical output in each of semiconductor light-emitting elements 100 and 100A.
Fig. 13B is a graph showing a relation between a current and external quantum efficiency in each of semiconductor light-emitting elements 100 and 100A.
Fig. 14A is a first graph showing a relation between an angle θ1 and light extraction efficiency in semiconductor light-emitting element 100.
Fig. 14B is a second graph showing the relation between angle θ1 and the light extraction efficiency in semiconductor light-emitting element 100.
Fig. 15 is a graph showing a relation between an angle θ2 and the light extraction efficiency in semiconductor light-emitting element 100.
Fig. 16 is a plan view of a semiconductor light-emitting element 200.
Fig. 17 is a plan view of semiconductor light-emitting element 200 as viewed from a side opposite to that shown in Fig. 16.
Fig. 18A is a cross-sectional view taken along XVIII-XVIII in Fig. 16.
Fig. 18B is an example of a bird's-eye SEM photograph in semiconductor light-emitting element 200.
Fig. 19A is a graph showing a relation between a current and an optical output in each of semiconductor light-emitting elements 200 and 200A.
Fig. 19B is a graph showing a relation between a current and external quantum efficiency in each of semiconductor light-emitting elements 200 and 200A.
Fig. 20 is a graph showing a relation between an angle θ1 and light extraction efficiency in semiconductor light-emitting element 200.
Fig. 21 is a graph showing a relation between an angle θ2 and light extraction efficiency in semiconductor light-emitting element 200.
Fig. 22 is a graph showing a relation between angle θ1 and a full width half maximum of an emission angle of deep ultraviolet light in semiconductor light-emitting element 200.
Fig. 23A is a graph showing an emission angle and intensity of the deep ultraviolet light in semiconductor light-emitting element 200 on condition that angle θ1 is -5°.
Fig. 23B is a graph showing the emission angle and the intensity of the deep ultraviolet light in semiconductor light-emitting element 200 on condition that angle θ1 is 26°.
Fig. 23C is a graph showing the emission angle and the intensity of the deep ultraviolet light in semiconductor light-emitting element 200 on condition that angle θ1 is 35°.
Fig. 23D is a graph showing the emission angle and the intensity of the deep ultraviolet light in semiconductor light-emitting element 200 on condition that angle θ1 is 50°.
Fig. 24 is a graph showing the relation between angle θ1 and the full width half maximum of the emission angle of the deep ultraviolet light in semiconductor light-emitting element 200 on condition that a width W1 is changed.
Fig. 25 is a plan view of a semiconductor light-emitting element 300.
Fig. 26 is a plan view of semiconductor light-emitting element 300 as viewed from a side opposite to that shown in Fig. 25.
Fig. 27 is a cross-sectional view taken along XXVII-XXVII in Fig. 25.
Fig. 28 is a graph showing a relation between an angle θ1 and light extraction efficiency in semiconductor light-emitting element 300.
Fig. 29 is a graph showing a relation between an angle θ2 and the light extraction efficiency in semiconductor light-emitting element 300.
Fig. 30 is a graph showing a relation between a thickness T and the light extraction efficiency in semiconductor light-emitting element 300.
Fig. 31 is a cross-sectional view of a semiconductor light-emitting element 400.
Fig. 32 is a diagram of a process for manufacturing semiconductor light-emitting element 400.
Fig. 33 is a cross-sectional view of a light-emitting module 500.
Fig. 34 is a diagram of a process for manufacturing light-emitting module 500.
Fig. 35 is a diagram of a process for manufacturing light-emitting module 500 according to a modification.
Fig. 36 is a graph showing a relation between a current and an output of deep ultraviolet light in light-emitting module 500.
Fig. 37 is a graph showing a relation between the current and extraction efficiency for deep ultraviolet light in light-emitting module 500.

### DESCRIPTION OF EMBODIMENTS

Details of embodiments will be hereinafter described with reference to the accompanying drawings. In the drawings referred to below, the same or corresponding portions are denoted by the same reference characters, and redundant description will not be repeated.

### (First Embodiment)

A semiconductor light-emitting element according to the first embodiment will be hereinafter described. The semiconductor light-emitting element according to the first embodiment is referred to as a semiconductor light-emitting element 100.

### <Configuration of Semiconductor Light-Emitting Element 100>

The following describes a configuration of semiconductor light-emitting element 100.

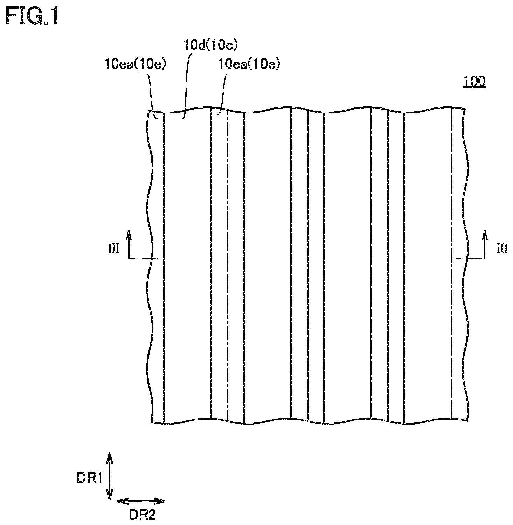

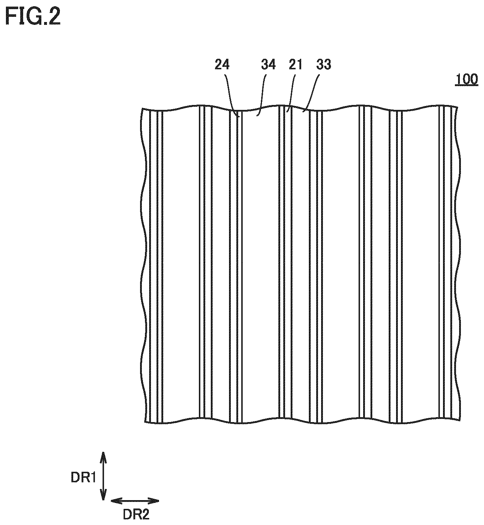

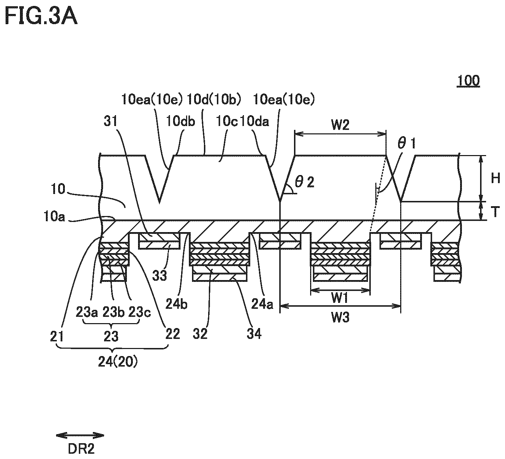

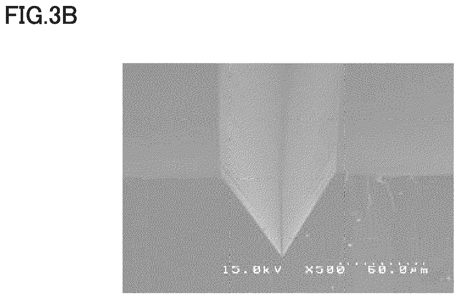

Fig. 1 is a plan view of semiconductor light-emitting element 100. Fig. 2 is a plan view of semiconductor light-emitting element 100 as viewed from the side opposite to that shown in Fig. 1. Fig. 3A is a cross-sectional view taken along III-III in Fig. 1. Fig. 3B is an example of a cross-sectional SEM photograph in semiconductor light-emitting element 100. As shown in Figs. 1 to 3B, semiconductor light-emitting element 100 includes a substrate 10, a semiconductor layer 20, an n-electrode 31, a p-electrode 32, and pad electrodes 33 and 34.

Substrate 10 has a first main surface 10a and a second main surface 10b. First main surface 10a and second main surface 10b are end surfaces of substrate 10 in a thickness direction thereof. Second main surface 10b is a surface opposite to first main surface 10a. The constituent material of substrate 10 is a single crystal of aluminum nitride (AlN). The constituent material of substrate 10 is preferably a single crystal of aluminum nitride produced by a sublimation method (physical vapor transport: PVT). The absorption coefficient of substrate 10 with respect to deep ultraviolet light may be 1 cm⁻¹ or more and 50 cm⁻¹ or less. The deep ultraviolet light has a wavelength of 100 nm or more and 350 nm or less, and more narrowly, has a wavelength of 200 nm or more and 300 nm or less. Second main surface 10b is preferably a "-c plane" (an N (nitrogen) polar plane) of aluminum nitride.

Semiconductor layer 20 includes an n-type semiconductor layer 21, an active layer 22, and a p-type semiconductor layer 23. Further, n-type semiconductor layer 21 is disposed on first main surface 10a. Active layer 22 is disposed on n-type semiconductor layer 21. Further, p-type semiconductor layer 23 includes an electron blocking layer 23a disposed on active layer 22, a cladding layer 23b disposed on electron blocking layer 23a, and a contact layer 23c disposed on cladding layer 23b.

The constituent material of n-type semiconductor layer 21 is, for example, AlGaN. The constituent material of n-type semiconductor layer 21 may be AlInGaN. The constituent material of n-type semiconductor layer 21 is doped with n-type impurities. Examples of the n-type impurities include silicon (Si), germanium (Ge), tin (Sn), oxygen (O), carbon (C), and the like.

Active layer 22 has, for example, a multiple quantum well (MQW) structure. More specifically, active layer 22 includes well layers and barrier layers that are alternately stacked. The constituent material of the well layer is, for example, AlGaN or AlInGaN. The constituent material of the barrier layer is, for example, AlGaN or AlInGaN. Deep ultraviolet light is generated from active layer 22.

The constituent material of electron blocking layer 23a is, for example, AlGaN or AlN. The constituent material of cladding layer 23b is, for example, AlGaN. The constituent material of contact layer 23c is, for example, GaN. The constituent material of p-type semiconductor layer 23 is doped with p-type impurities. Examples of the p-type impurities include magnesium (Mg), zinc (Zn), beryllium (Be), and the like.

Semiconductor layer 20 has a plurality of mesa structures 24 in a cross-sectional view. In semiconductor light-emitting element 100, semiconductor layer 20 has the plurality of mesa structures 24 in a cross-sectional view orthogonal to a first direction DR1, but semiconductor layer 20 may have the plurality of mesa structures 24 in one of cross-sectional views. Around mesa structure 24, active layer 22 and p-type semiconductor layer 23 are removed so as to expose n-type semiconductor layer 21. Mesa structure 24 extends in first direction DR1 in a plan view. The plurality of mesa structures 24 are arranged at intervals in a second direction DR2. Second direction DR2 is orthogonal to first direction DR1 in a plan view. The plurality of mesa structures 24 are formed, for example, in a shape like teeth of a comb in a plan view.

The width of mesa structure 24 is defined as a width W1. In semiconductor light-emitting element 100, width W1 is measured in second direction DR2. Mesa structure 24 has a first end 24a and a second end 24b. In semiconductor light-emitting element 100, first end 24a and second end 24b are both ends of mesa structure 24 in second direction DR2.

A plurality of protrusions 10c are formed on second main surface 10b. Each protrusion 10c extends in first direction DR1 in a plan view. The plurality of protrusions 10c are arranged in second direction DR2. Each protrusion 10c faces each mesa structure 24. Preferably, the center of protrusion 10c in second direction DR2 overlaps with the center of mesa structure 24 in second direction DR2.

Protrusion 10c has a top surface 10d and a side surface 10e. Top surface 10d is formed by second main surface 10b. In other words, top surface 10d is a "-c plane" (an N polar plane) of aluminum nitride. Side surface 10e has an upper end contiguous to top surface 10d. In semiconductor light-emitting element 100, side surface 10e includes a first side surface 10ea and a second side surface 10eb. First side surface 10ea and second side surface 10eb each have an upper end contiguous to top surface 10d. First side surface 10ea and second side surface 10eb face each other in second direction DR2.

The lower end of first side surface 10ea of one protrusion 10c is preferably contiguous to the lower end of second side surface 10eb of another protrusion 10c adjacent to the one protrusion 10c. From a different point of view, second main surface 10b is provided with a recess having a sidewall surface formed by first side surface 10ea and second side surface 10eb, and the recess has a V-shape in a cross-sectional view orthogonal to first direction DR1.

Top surface 10d has a third end 10da and a fourth end 10db. In semiconductor light-emitting element 100, third end 10da and fourth end 10db are both ends of top surface 10d in second direction DR2. In semiconductor light-emitting element 100, third end 10da is a ridgeline between top surface 10d and first side surface 10ea, and fourth end 10db is a ridgeline between top surface 10d and second side surface 10eb. First end 24a is located closer to third end 10da than to fourth end 10db.

Top surface 10d has a width W2. In semiconductor light-emitting element 100, width W2 denotes a width of top surface 10d in second direction DR2. From a different point of view, in semiconductor light-emitting element 100, width W2 is a distance between third end 10da and fourth end 10db in second direction DR2. Width W2 may be greater than width W1, may be less than width W1, or may be equal to width W1.

Protrusion 10c has a width W3. In semiconductor light-emitting element 100, width W3 is a distance between the lower end of first side surface 10ea and the lower end of second side surface 10eb in second direction DR2. The width of protrusion 10c in second direction DR2 increases with distance from top surface 10d. In other words, in a cross-sectional view orthogonal to first direction DR1, protrusion 10c has a trapezoidal shape in which the length (width W2) of the upper base is shorter than the length (width W3) of the lower base.

An angle formed by an imaginary straight line (a dotted line in Fig. 3A) passing through first end 24a and third end 10da and a direction normal to second main surface 10b is defined as an angle θ1. Angle θ1 is, for example, -25° or more and 65° or less. Angle θ1 having a negative value means that width W1 is larger than width W2. Angle θ1 is preferably -10° or more and 30° or less, and more preferably 0° or more and 20° or less. Angle θ1 can be calculated by tan⁻¹{(W2-W1)/2L}, where L is a distance between active layer 22 and top surface 10d.

An angle formed by side surface 10e (first side surface 10ea and second side surface 10eb) and top surface 10d is defined as an angle θ2. Angle θ2 is, for example, 56° ± 20°. Angle θ2 is preferably 56° ± 10°, and more preferably 56° ± 6°. The thickness of substrate 10 between two adjacent protrusions 10c is defined as a thickness T. Thickness T is 90 µm or less. Thickness T is preferably 50 µm or less, more preferably 40 µm or less, and particularly preferably 30 µm or less. Thickness T may be 0.

The height of protrusion 10c is defined as a height H. Height H is a distance between a lower end of side surface 10e (first side surface 10ea and second side surface 10eb) and top surface 10d. In semiconductor light-emitting element 100, a value obtained by dividing height H by width W1 is preferably 0.1 or more, more preferably 0.3 or more, and particularly preferably 0.5 or more and 3 or less.

Further, n-electrode 31 is disposed on n-type semiconductor layer 21 exposed from between mesa structures 24 in a plan view. Further, p-electrode 32 is disposed on p-type semiconductor layer 23 (more specifically, contact layer 23c). The constituent materials of n-electrode 31 and p-electrode 32 are, for example, metal materials. Further, n-electrode 31 is formed, for example, by stacking a titanium (Ti) layer, an aluminum layer, and a gold (Au) layer in this order from the n-type semiconductor layer 21 side. Further, p-electrode 32 is formed, for example, by stacking a nickel (Ni) layer and a gold layer in this order from the p-type semiconductor layer 23 side.

Pad electrode 33 is disposed on n-electrode 31. The constituent material of pad electrode 33 is, for example, a metal material. Pad electrode 33 is formed by stacking a titanium layer, an aluminum layer, and a gold layer in this order from the n-electrode 31 side. Pad electrode 34 is disposed on p-electrode 32. The constituent material of pad electrode 34 is, for example, a metal material. Pad electrode 34 is formed by stacking a titanium layer, an aluminum layer, and a gold layer in this order from the p-electrode 32 side.

### <Modification>

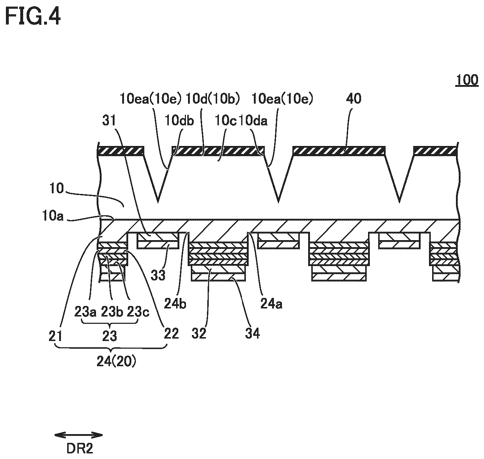

Fig. 4 is a cross-sectional view of a semiconductor light-emitting element 100 according to a modification. As shown in Fig. 4, semiconductor light-emitting element 100 may further include an anti-reflection film 40. The constituent material of anti-reflection film 40 is, for example, silicon dioxide (SiO₂). Anti-reflection film 40 is disposed on top surface 10d.

### <Method of Manufacturing Semiconductor Light-Emitting Element 100>

The following describes a method of manufacturing semiconductor light-emitting element 100.

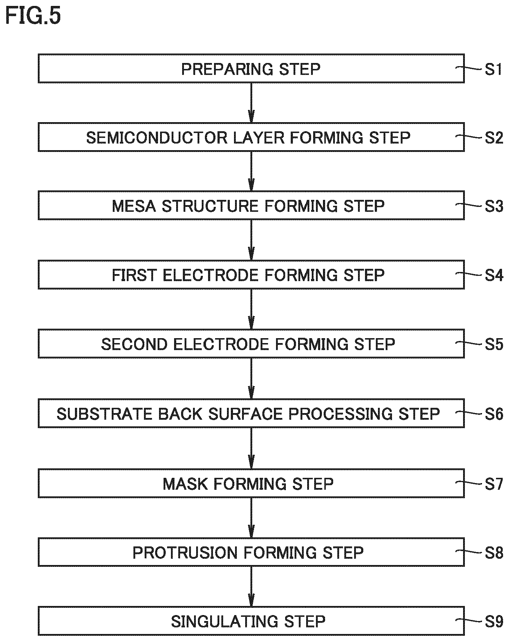

Fig. 5 is a diagram of a process for manufacturing semiconductor light-emitting element 100. As shown in Fig. 5, the method of manufacturing semiconductor light-emitting element 100 includes a preparing step S1, a semiconductor layer forming step S2, a mesa structure forming step S3, a first electrode forming step S4, a second electrode forming step S5, a substrate back surface processing step S6, a mask forming step S7, a protrusion forming step S8, and a singulating step S9.

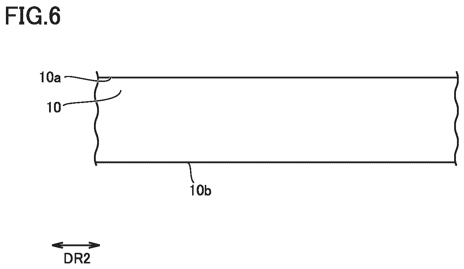

In the method of manufacturing semiconductor light-emitting element 100, preparing step S1 is first performed. Fig. 6 is a cross-sectional view illustrating preparing step S1. As shown in Fig. 6, in preparing step S1, substrate 10 is prepared. In substrate 10 prepared in preparing step S1, semiconductor layer 20 is not formed on first main surface 10a, and the plurality of protrusions 10c are not formed on second main surface 10b.

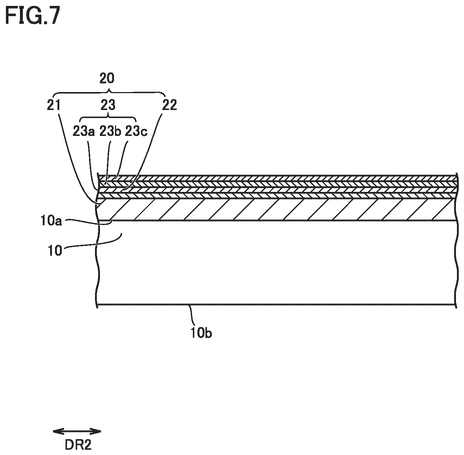

Semiconductor layer forming step S2 is performed after preparing step S1. Fig. 7 is a cross-sectional view illustrating semiconductor layer forming step S2. As shown in Fig. 7, in semiconductor layer forming step S2, semiconductor layer 20 is formed. Each of layers constituting semiconductor layer 20 is formed, for example, by a metal organic chemical vapor deposition (MOCVD) method. After semiconductor layer 20 is formed, annealing is performed to activate p-type semiconductor layer 23.

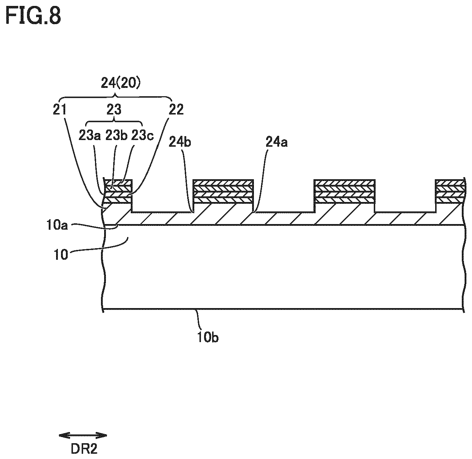

Mesa structure forming step S3 is performed after semiconductor layer forming step S2. Fig. 8 is a cross-sectional view illustrating mesa structure forming step S3. As shown in Fig. 8, in mesa structure forming step S3, mesa structure 24 is formed in semiconductor layer 20. In mesa structure forming step S3, firstly, a mask is formed on semiconductor layer 20. The mask is formed, for example, of a metal material such as nickel. Secondly, anisotropic etching is performed using the above-mentioned mask. Thereby, mesa structure 24 is formed. Thirdly, the mask is removed.

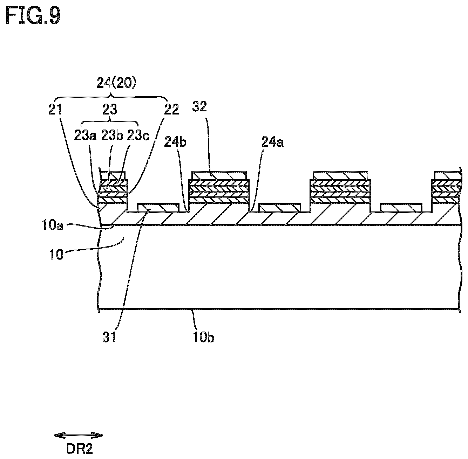

First electrode forming step S4 is performed after mesa structure forming step S3. Fig. 9 is a cross-sectional view illustrating first electrode forming step S4. As shown in Fig. 9, in first electrode forming step S4, n-electrode 31 and p-electrode 32 are formed. In first electrode forming step S4, n-electrode 31 and p-electrode 32 are sequentially formed, for example, by a vacuum deposition method. After n-electrode 31 and p-electrode 32 are formed, annealing is performed.

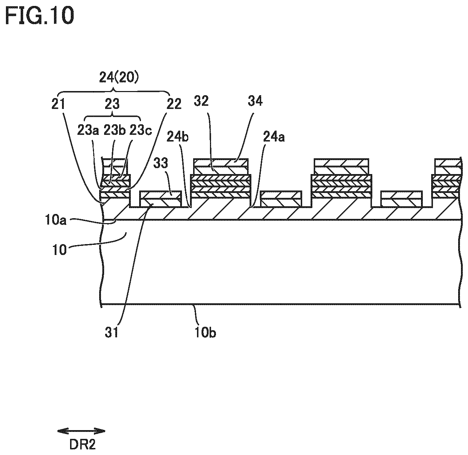

Second electrode forming step S5 is performed after first electrode forming step S4. Fig. 10 is a cross-sectional view illustrating second electrode forming step S5. As shown in Fig. 10, in second electrode forming step S5, pad electrodes 33 and 34 are formed. In second electrode forming step S5, pad electrodes 33 and 34 are formed, for example, by a vacuum deposition method.

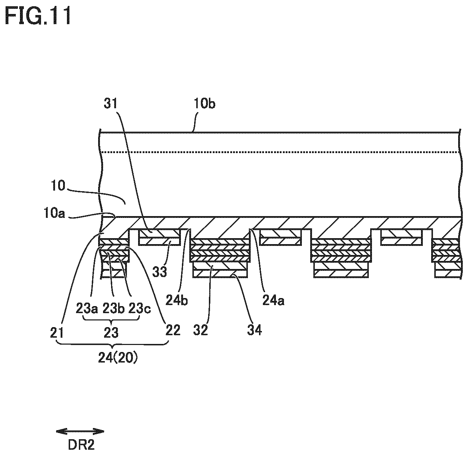

Substrate back surface processing step S6 is performed after second electrode forming step S5. Fig. 11 is a cross-sectional view illustrating substrate back surface processing step S6. As shown in Fig. 11, in substrate back surface processing step S6, second main surface 10b is machined (ground and polished). Thereby, substrate 10 is reduced in thickness.

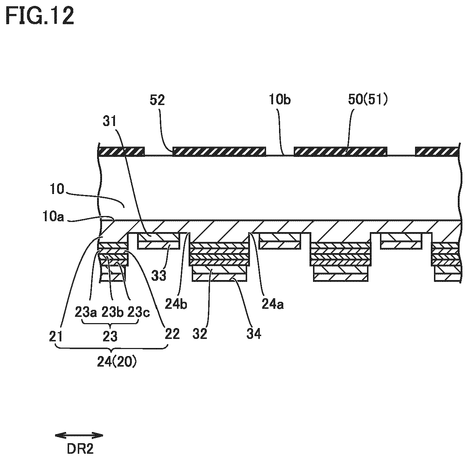

Mask forming step S7 is performed after substrate back surface processing step S6. Fig. 12 is a cross-sectional view illustrating mask forming step S7. As shown in Fig. 12, in mask forming step S7, mask 50 is formed on second main surface 10b. Mask 50 has a plurality of patterns 51. Each pattern 51 extends in first direction DR1 in a plan view in the state in which each pattern 51 faces each mesa structure 24. The plurality of patterns 51 are arranged at intervals in second direction DR2. An opening 52 of mask 50 is formed between two adjacent patterns 51. The constituent material of mask 50 is preferably the same as the constituent material of anti-reflection film 40.

When forming mask 50, firstly, a film is formed of the constituent material of mask 50. Such formation of a film from the constituent material of mask 50 is preferably done, for example, by the plasma-enhanced chemical vapor deposition (PE-CVD) method. Formation of a film from the constituent material of mask 50 may be done by a vapor deposition method, a sputtering method, or an atomic layer deposition (ALD) method instead of the PE-CVD method. Secondly, the constituent material of mask 50 formed as a film is patterned. Patterning is performed by etching the constituent material of mask 50 formed as a film, with use of a resist pattern formed by photolithography. As the constituent material of mask 50, a resist having thermal alkali resistance may be used. In this case, mask 50 may be formed directly by photolithography. The patterning is formed after making an alignment with respect to the position of mesa structure 24. Examples of the method of alignment used in this case include a method of a see-through inspection of mesa structure 24 and an alignment mark from the second main surface 10b side of substrate 10 with use of an apparatus capable of achieving double-sided alignment. Further, the alignment may be made with reference to an edge of substrate 10.

Protrusion forming step S8 is performed after mask forming step S7. In protrusion forming step S8, a plurality of protrusions 10c are formed by wet etching substrate 10 exposed from opening 52 with use of mask 50. This wet etching is performed using a hot alkaline solution. The hot alkaline solution is, for example, a tetramethylammonium hydroxide aqueous solution (TMAH). The hot alkaline solution may be a potassium hydroxide (KOH) aqueous solution.

Wet etching is performed with use of a hot alkaline solution to form a recess in second main surface 10b exposed from the opening. In a cross-sectional view orthogonal to first direction DR1, the recess has a first sidewall surface and a second sidewall surface facing the first sidewall surface with a space being interposed therebetween. Wet etching using a hot alkaline solution proceeds such that the first sidewall surface and the second sidewall surface form a constant angle (for example, 56° ± 6°) with respect to second main surface 10b (see Fig. 3B). When the wet etching using the hot alkaline solution proceeds, the lower end of the first sidewall surface and the lower end of the second sidewall surface come into contact with each other, and then, the wet etching stops proceeding.

After the wet etching, the first sidewall surface becomes first side surface 10ea of one protrusion 10c, the second sidewall surface becomes second side surface 10eb of another protrusion 10c adjacent to the one protrusion 10c, and second main surface 10b below pattern 51 becomes top surface 10d. Mask 50 may be removed after protrusion forming step S8, or may be remained after protrusion forming step S8. When mask 50 is remained after protrusion forming step S8, remained pattern 51 becomes anti-reflection film 40.

Singulating step S9 is performed after protrusion forming step S8. In singulating step S9, dicing is performed for singulation to produce a plurality of semiconductor light-emitting elements 100. Thereby, semiconductor light-emitting element 100 having the structure shown in Figs. 1 to 3A is manufactured.

### <Effects of Semiconductor Light-Emitting Element 100>

The following describes the effects of semiconductor light-emitting element 100.

In semiconductor light-emitting element 100, semiconductor layer 20 has a plurality of mesa structures 24, and a plurality of protrusions 10c are formed on second main surface 10b. Further, in semiconductor light-emitting element 100, one mesa structure 24 faces one protrusion 10c. Thus, the deep ultraviolet light inside a light escape cone is extracted from top surface 10d, and the deep ultraviolet light outside the light escape cone is also extracted from side surface 10e (first side surface 10ea and second side surface 10eb).

Further, in semiconductor light-emitting element 100, protrusion 10c is formed by deeply etching substrate 10 so as to have thickness T of 90 µm or less. In general, it is difficult to deeply etch substrate 10 by dry etching, and it is difficult to accurately etch the substrate by wet etching. However, in semiconductor light-emitting element 100, second main surface 10b is formed as a "-c plane" (an N polar plane) of aluminum nitride and a hot alkaline solution is used for wet etching. Thereby, wet etching proceeds such that the first sidewall surface and the second sidewall surface of the recess that face each other at intervals form a constant angle with respect to second main surface 10b.

This wet etching is stopped when the lower end of the first sidewall surface and the lower end of the second sidewall surface come into contact with each other, and thus, protrusion 10c is formed with higher processing accuracy, so that the accuracy of the dimensions of protrusion 10c can be ensured, and the accurate correspondence relation with mesa structure 24 can be ensured. Also, deeply etching substrate 10 results in a shorter distance through which the deep ultraviolet light generated in active layer 22 passes before the deep ultraviolet light is extracted to the outside of substrate 10, with the result that absorption of the deep ultraviolet light in substrate 10 made of aluminum nitride decreases. In this way, according to semiconductor light-emitting element 100, the extraction efficiency for deep ultraviolet light can be improved.

The semiconductor light-emitting element according to the comparative example is referred to as a semiconductor light-emitting element 100A. The configuration of semiconductor light-emitting element 100A is the same as that of semiconductor light-emitting element 100 except that the plurality of protrusions 10c are not formed on second main surface 10b (i.e., second main surface 10b is configured as a flat surface).

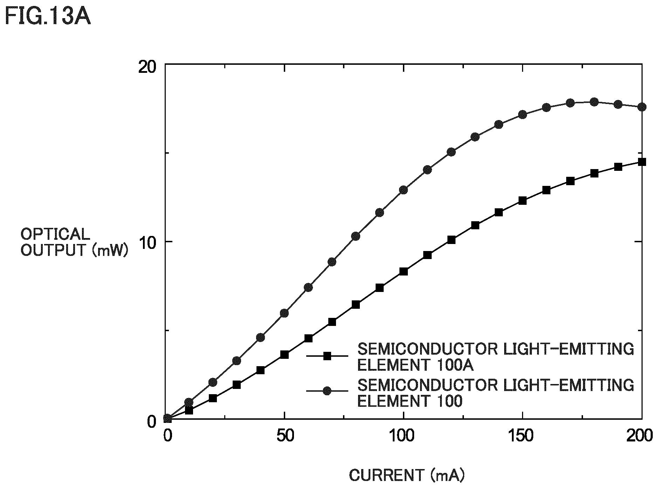

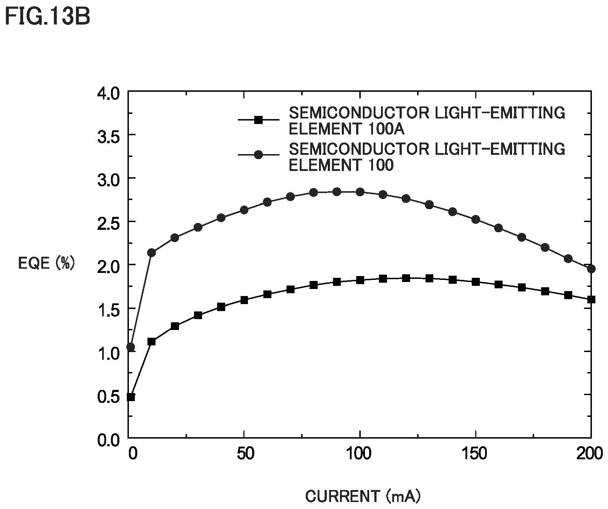

Fig. 13A is a graph showing the relation between the current and the optical output in each of semiconductor light-emitting elements 100 and 100A. Fig. 13B is a graph showing the relation between the current and the external quantum efficiency in each of semiconductor light-emitting elements 100 and 100A. As shown in Figs. 13A and 13B, semiconductor light-emitting element 100 exhibits an optical output and external quantum efficiency (EQE) higher than those in the case of semiconductor light-emitting element 100A. More specifically, when a current of 100 mA flows, semiconductor light-emitting element 100 exhibits the optical output and the external quantum efficiency that are 1.55 times as large as those in the case of semiconductor light-emitting element 100A. This comparison supports that semiconductor light-emitting element 100 enables improvement in extraction efficiency for deep ultraviolet light.

In Figs. 13A and 13B, the chip size is 1 mm × 1 mm, and the area of mesa structure 24 in a plan view is 0.30 mm². In Figs. 13A and 13B, in semiconductor light-emitting element 100, widths W1 and W2 each are 90 µm, width W3 is 180 µm, angle θ2 is 56°, thickness T is 34 µm, and height H is 67 µm. Figs. 13A and 13B show experimental values of the relation between the current and the optical output or the external quantum efficiency.

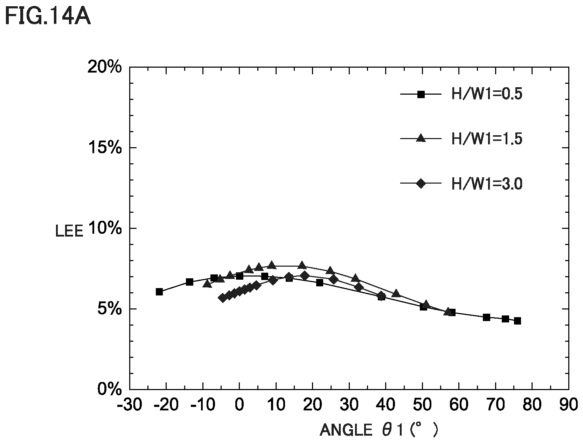

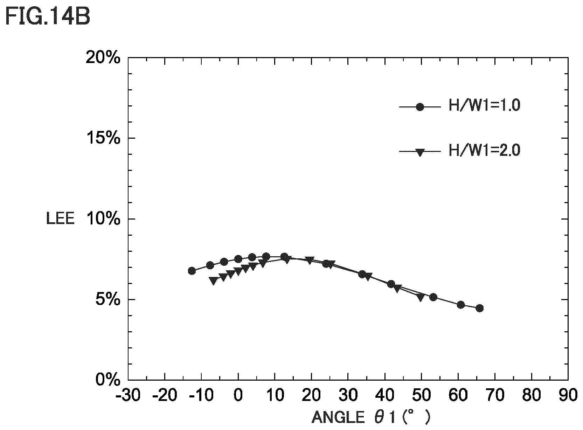

Fig. 14A is a first graph showing the relation between angle θ1 and the light extraction efficiency in semiconductor light-emitting element 100. Fig. 14B is a second graph showing the relation between angle θ1 and the light extraction efficiency in semiconductor light-emitting element 100. As shown in Figs. 14A and 14B, in semiconductor light-emitting element 100, the extraction efficiency for deep ultraviolet light (light extraction efficiency: LEE) is particularly improved in the range in which angle θ1 is -25° or more and 65° or less, and the extraction efficiency for deep ultraviolet light is further improved in the range in which angle θ1 is -10° or more and 30° or less. In this way, angle θ1 is preferably -25° or more and 65° or less, and more preferably -10° or more and 30° or less. Figs. 14A and 14B show the relation between angle θ1 and the light extraction efficiency that are calculated using the ray tracing method.

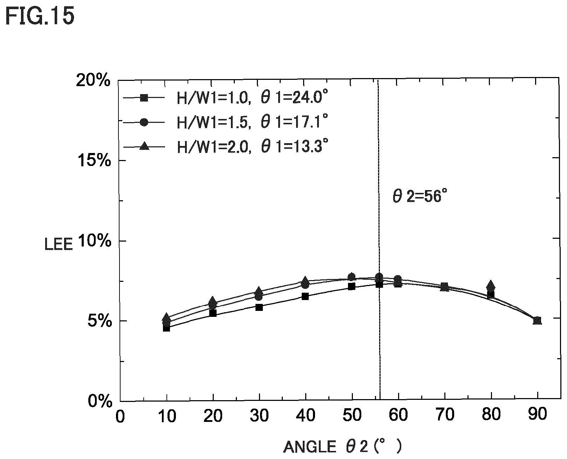

Fig. 15 is a graph showing the relation between angle θ2 and the light extraction efficiency in semiconductor light-emitting element 100. As shown in Fig. 15, in semiconductor light-emitting element 100, the extraction efficiency for deep ultraviolet light becomes maximum when angle θ2 is about 56°. Further, in semiconductor light-emitting element 100, the extraction efficiency for deep ultraviolet light is particularly improved when angle θ2 is 56° ± 20°, and the extraction efficiency for deep ultraviolet light is further improved when angle θ2 is 56° ± 10°. Based on the above, angle θ2 is preferably 56° ± 20°, and more preferably 56° ± 10°. Fig. 15 shows the relation between angle θ2 and the light extraction efficiency that are calculated using the ray tracing method.

In Figs. 14A, 14B, and 15, the value obtained by dividing height H by width W1 is changed, angle θ2 is 56°, width W2 is 90 µm, thickness T is 10 µm, and the absorption coefficient of substrate 10 with respect to deep ultraviolet light is 10 cm⁻¹.

### (Second Embodiment)

A semiconductor light-emitting element according to the second embodiment will be hereinafter described.

The semiconductor light-emitting element according to the second embodiment is referred to as a semiconductor light-emitting element 200. In the following, differences from semiconductor light-emitting element 100 will be mainly described, and redundant description will not be repeated.

### <Configuration of Semiconductor Light-Emitting Element 200>

The following describes a configuration of semiconductor light-emitting element 200.

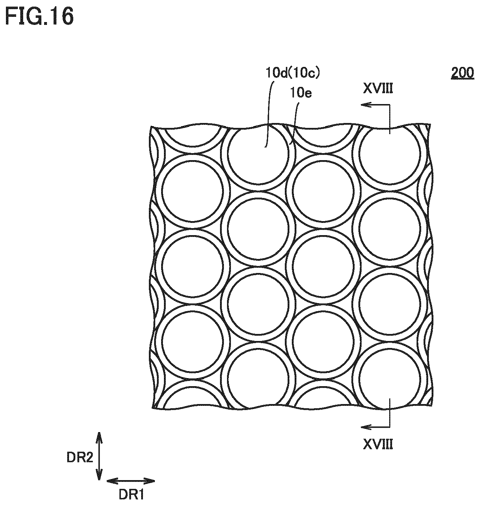

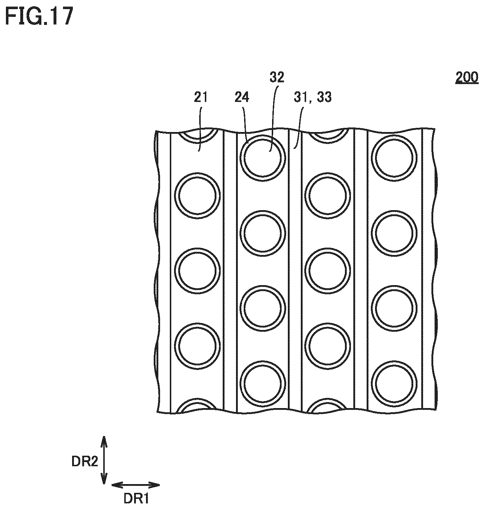

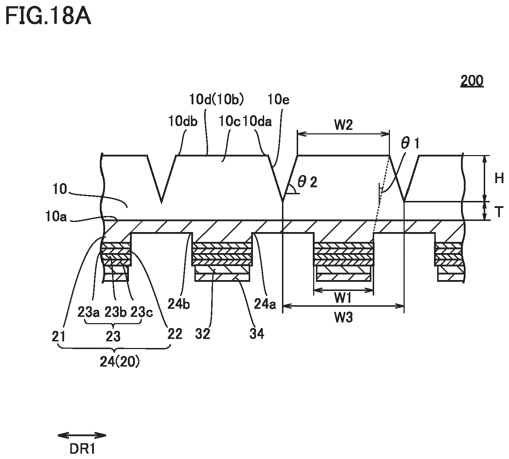

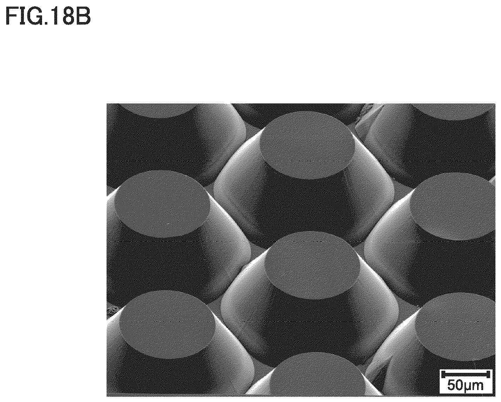

Fig. 16 is a plan view of semiconductor light-emitting element 200. Fig. 17 is a plan view of semiconductor light-emitting element 200 as viewed from the side opposite to that shown in Fig. 16. Fig. 17 does not show pad electrode 34. Fig. 18A is a cross-sectional view taken along XVIII-XVIII in Fig. 16. Fig. 18B is an example of a bird's-eye SEM photograph in semiconductor light-emitting element 200. As shown in Figs. 16 to 18B, semiconductor light-emitting element 200 includes substrate 10, semiconductor layer 20, n-electrode 31, p-electrode 32, and pad electrode 33. In this respect, the configuration of semiconductor light-emitting element 200 is the same as that of semiconductor light-emitting element 100.

In semiconductor light-emitting element 200, mesa structure 24 is circular in a plan view. In semiconductor light-emitting element 200, first end 24a and second end 24b are both ends of mesa structure 24 in a cross-sectional view orthogonal to second main surface 10b and passing through the center of mesa structure 24 in a plan view. In semiconductor light-emitting element 200, width W1 is a diameter of mesa structure 24 in a plan view. In semiconductor light-emitting element 200, a plurality of mesa structures 24 are arranged in a regular triangular lattice pattern in a plan view.

In semiconductor light-emitting element 200, protrusion 10c has a truncated conical shape. In other words, in semiconductor light-emitting element 200, top surface 10d is circular in a plan view, side surface 10e is formed as a conical surface, and the diameter of side surface 10e increases with distance from top surface 10d. In semiconductor light-emitting element 200, third end 10da and fourth end 10db are both ends of top surface 10d in a cross-sectional view orthogonal to second main surface 10b and passing through the center of top surface 10d in a plan view. In semiconductor light-emitting element 200, width W2 is a diameter of top surface 10d, and width W3 is a diameter of side surface 10e at the lower end. In semiconductor light-emitting element 200, the plurality of protrusions 10c are arranged in a regular triangular lattice pattern such that the lower ends of side surfaces 10e are in contact with each other (see Fig. 18B). In semiconductor light-emitting element 200, the center of top surface 10d preferably overlaps with the center of mesa structure 24 in a plan view.

In semiconductor light-emitting element 200, angle θ1 is formed by top surface 10d and an imaginary straight line (see a dotted line in Fig. 18A) passing through the center of top surface 10d in a plan view and passing through first end 24a and third end 10da in a cross-sectional view orthogonal to second main surface 10b. In semiconductor light-emitting element 200, the value obtained by dividing height H by width W1 is preferably 0.1 or more, more preferably 0.3 or more, and particularly preferably 0.5 or more and 5 or less.

In semiconductor light-emitting element 200, angle θ1 is, for example, -20° or more and 65° or less, preferably -10° or more and 30° or less, and more preferably 0° or more and 20° or less, as in semiconductor light-emitting element 100. In addition, in semiconductor light-emitting element 200, angle θ2 is preferably -5° or more and 32° or less, and more preferably 10° or more and 20° or less from the viewpoint of enhancing the directivity of the deep ultraviolet light while maintaining the intensity of the deep ultraviolet light to be emitted. In these respects, the configuration of semiconductor light-emitting element 200 is different from that of semiconductor light-emitting element 100.

### <Method of Manufacturing Semiconductor Light-Emitting Element 200>

The following describes a method of manufacturing semiconductor light-emitting element 200.

The method of manufacturing semiconductor light-emitting element 200 includes preparing step S1, semiconductor layer forming step S2, mesa structure forming step S3, first electrode forming step S4, second electrode forming step S5, substrate back surface processing step S6, mask forming step S7, protrusion forming step S8, and singulating step S9. In this respect, the method of manufacturing semiconductor light-emitting element 200 is the same as the method of manufacturing semiconductor light-emitting element 100.

In the method of manufacturing semiconductor light-emitting element 200, in mask forming step S7, pattern 51 is formed in a circular shape in a plan view, and the plurality of patterns 51 are arranged in a regular triangular lattice pattern in a plan view. In this respect, the method of manufacturing semiconductor light-emitting element 200 is different from the method of manufacturing semiconductor light-emitting element 100.

### <Effects of Semiconductor Light-Emitting Element 200>

The following describes the effects of semiconductor light-emitting element 200.

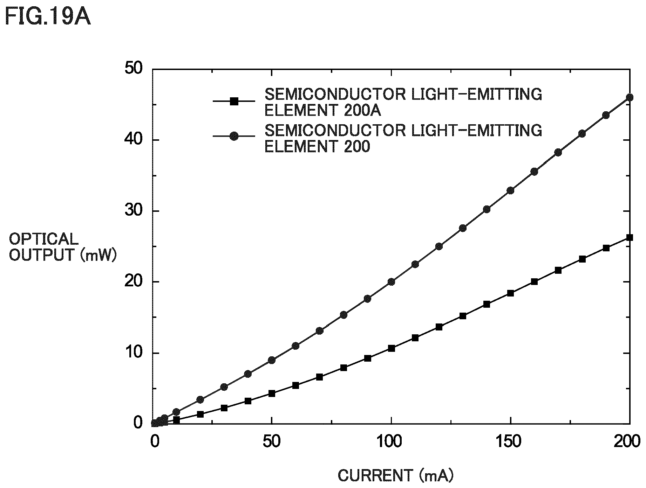

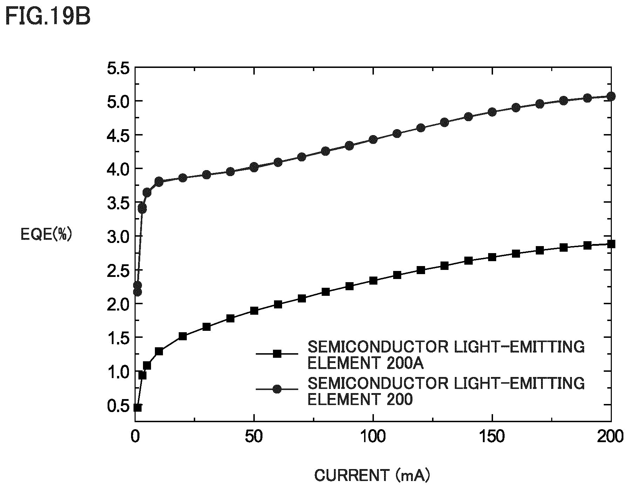

The semiconductor light-emitting element according to a comparative example is referred to as a semiconductor light-emitting element 200A. The configuration of semiconductor light-emitting element 200A is the same as that of semiconductor light-emitting element 200 except that the plurality of protrusions 10c are not formed on second main surface 10b. Fig. 19A is a graph showing the relation between the current and the optical output in each of semiconductor light-emitting elements 200 and 200A. Fig. 19B is a graph showing the relation between the current and the external quantum efficiency in each of semiconductor light-emitting elements 200 and 200A. As shown in Figs. 19A and 19B, semiconductor light-emitting element 200 exhibits an optical output and external quantum efficiency higher than those in the case of semiconductor light-emitting element 200A. More specifically, when a current of 200 mA flows, semiconductor light-emitting element 200 exhibits the optical output and the external quantum efficiency that are 1.89 times as large as those in the case of semiconductor light-emitting element 200A. This comparison supports that semiconductor light-emitting element 200 enables further improvement in extraction efficiency for deep ultraviolet light.

In Figs. 19A and 19B, the chip size is 2 mm × 2 mm, and the area of mesa structure 24 in a plan view is 0.778 mm². In Figs. 19A and 19B, in semiconductor light-emitting element 200, widths W1 and W2 each are 100 µm, width W3 is 175 µm, angle θ2 is 56° ± 6°, thickness T is 38 µm, and height H is 56 µm. Figs. 19A and 19B each show experimental values of the relation between the current and the optical output or the external quantum efficiency.

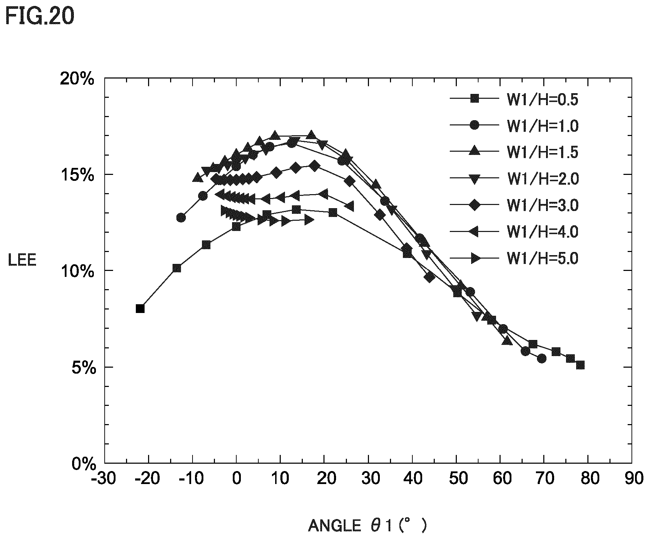

Fig. 20 is a graph showing the relation between angle θ1 and the light extraction efficiency in semiconductor light-emitting element 200. As shown in Fig. 20, in semiconductor light-emitting element 200, the extraction efficiency for deep ultraviolet light is particularly improved in the range in which angle θ1 is -10° or more and 30° or less, and the extraction efficiency for deep ultraviolet light is further improved in the range in which angle θ1 is 0° or more and 20° or less. Based on the above, also in semiconductor light-emitting element 200, angle θ1 is preferably in the range of -10° or more and 30° or less, and more preferably in the range of 0° or more and 20° or less. Fig. 20 shows the relation between angle θ1 and the light extraction efficiency that are calculated using the ray tracing method.

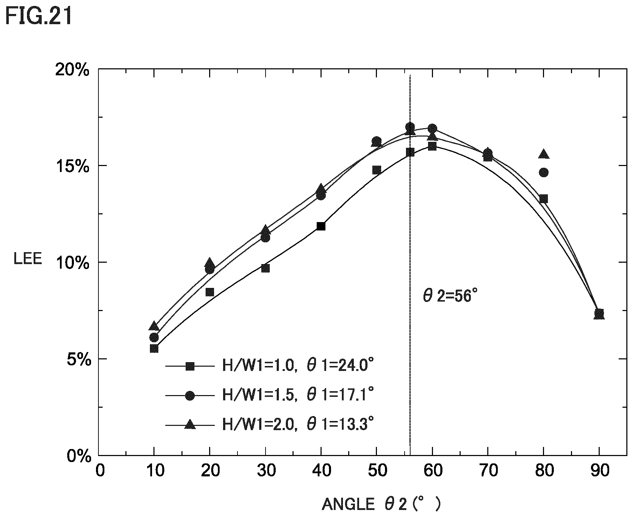

Fig. 21 is a graph showing the relation between angle θ2 and the light extraction efficiency in semiconductor light-emitting element 200. As shown in Fig. 21, in semiconductor light-emitting element 200, the extraction efficiency for deep ultraviolet light becomes maximum when angle θ2 is about 56°. Further, in semiconductor light-emitting element 200, the extraction efficiency for deep ultraviolet light is particularly improved when angle θ2 is 56° ± 10°, and the extraction efficiency for deep ultraviolet light is further improved when angle θ2 is 56° ± 6°. Based on the above, also in semiconductor light-emitting element 200, angle θ2 is preferably in the range of 56° ± 10°, and more preferably in the range of 56° ± 6°. In Figs. 20 and 21, the value obtained by dividing height H by width W2 is changed, angle θ2 is 56°, width W2 is 90 µm, the absorption coefficient of substrate 10 with respect to deep ultraviolet light is 10 cm⁻¹, and thickness T is 10 µm. Fig. 21 shows the relation between angle θ2 and the light extraction efficiency that are calculated using the ray tracing method.

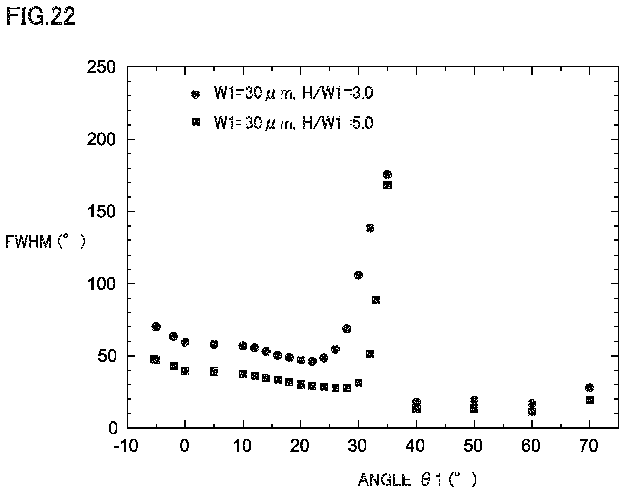

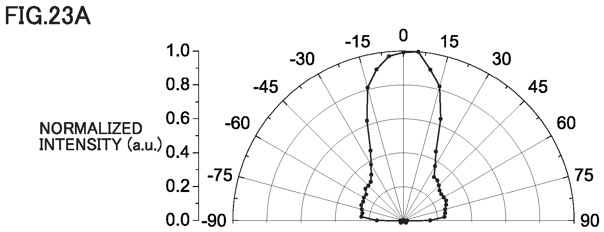

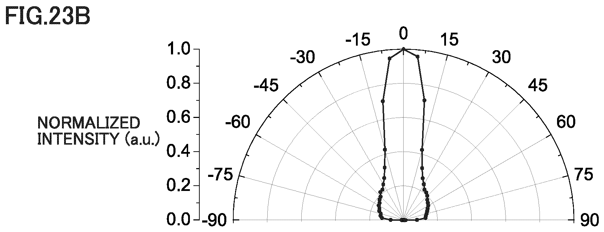

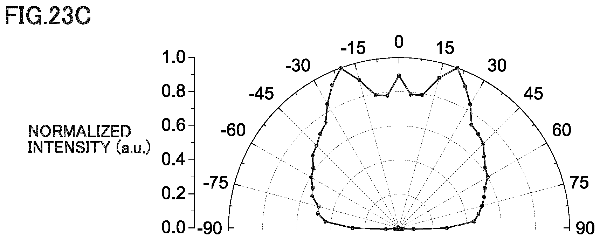

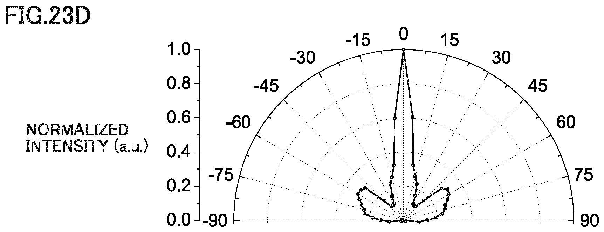

Fig. 22 is a graph showing the relation between angle θ1 and the full width half maximum of the emission angle of the deep ultraviolet light in semiconductor light-emitting element 200. Fig. 23A is a graph showing the emission angle and the intensity of the deep ultraviolet light in semiconductor light-emitting element 200 on condition that angle θ1 is -5°. Fig. 23B is a graph showing the emission angle and the intensity of the deep ultraviolet light in semiconductor light-emitting element 200 on condition that angle θ1 is 26°. Fig. 23C is a graph showing the emission angle and the intensity of the deep ultraviolet light in semiconductor light-emitting element 200 on condition that angle θ1 is 35°. Fig. 23D is a graph showing the emission angle and the intensity of the deep ultraviolet light in semiconductor light-emitting element 200 on condition that angle θ1 is 50°. In Figs. 22 to 23D, the full width half maximum and the intensity of the emission angle are calculated using the ray tracing method. As shown in Figs. 22 to 23D, in semiconductor light-emitting element 200, as angle θ2 increases toward 32°, the full width half maximum (FWMH) of the emitted deep ultraviolet light decreases. The full width half maximum of the emitted deep ultraviolet light is locally increased in the vicinity where angle θ2 is 32°. Further, the full width half maximum of the emitted deep ultraviolet light becomes smaller again when angle θ2 becomes 40° or more.

However, when angle θ2 is in the range of 40° or more, the full width half maximum of the emitted deep ultraviolet light decreases, but a peak of the intensity of the deep ultraviolet light occurs in the side direction (the direction in which the angle of inclination with respect to the direction normal to second main surface 10b becomes large) (see Fig. 23D). In the range in which angle θ2 is 40° or more, the intensity of the emitted deep ultraviolet light is relatively weak (see Fig. 20). Thus, in semiconductor light-emitting element 200, by setting angle θ1 to be -5° or more and 32° or less, the directivity of the emitted deep ultraviolet light can be enhanced while maintaining the intensity of the emitted deep ultraviolet light.

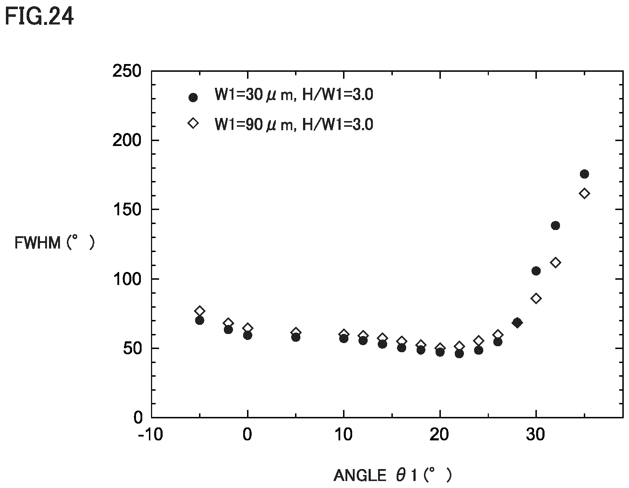

Fig. 24 is a graph showing the relation between angle θ1 and the full width half maximum of the emission angle of the deep ultraviolet light in semiconductor light-emitting element 200 on condition that width W1 is changed. As shown in Fig. 24, also when width W1 is changed, the relation between angle θ1 and the full width half maximum of the emission intensity of the emitted deep ultraviolet light shows the similar tendency. In Fig. 24, the full width half maximum of the emission angle is calculated using the ray tracing method.

### (Third Embodiment)

A semiconductor light-emitting element according to the third embodiment will be hereinafter described.

The semiconductor light-emitting element according to the third embodiment is referred to as a semiconductor light-emitting element 300. In the following, differences from semiconductor light-emitting element 100 will be mainly described, and redundant description will not be repeated.

### <Configuration of Semiconductor Light-Emitting Element 300>

The following describes a configuration of semiconductor light-emitting element 300.

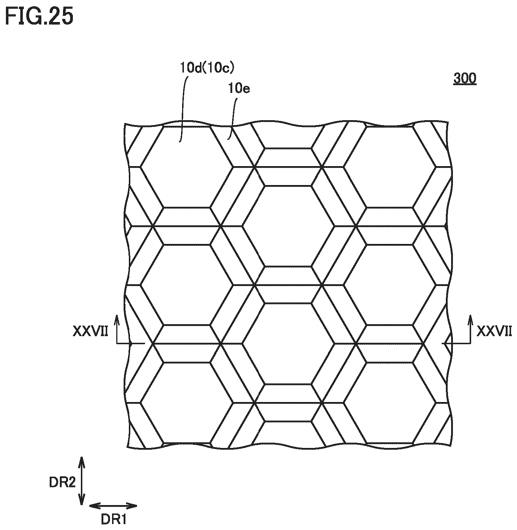

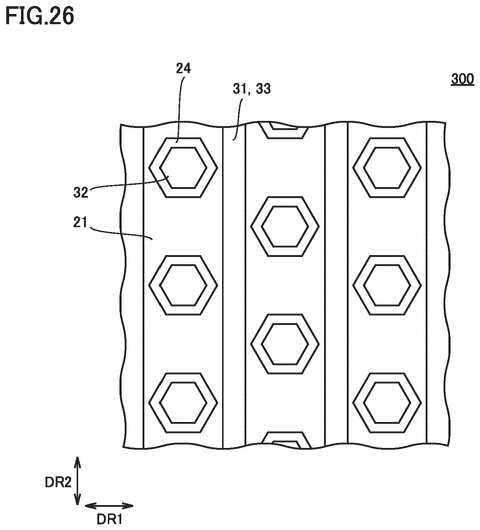

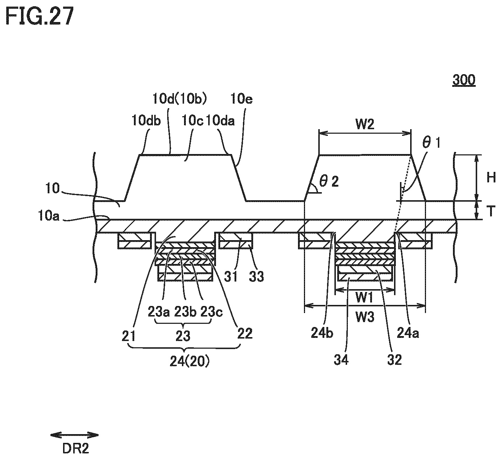

Fig. 25 is a plan view of semiconductor light-emitting element 300. Fig. 26 is a plan view of semiconductor light-emitting element 300 as viewed from the side opposite to that shown in Fig. 25. Fig. 26 does not show pad electrode 34. Fig. 27 is a cross-sectional view taken along XXVII-XXVII in Fig. 25. As shown in Figs. 25 to 27, semiconductor light-emitting element 300 includes substrate 10, semiconductor layer 20, n-electrode 31, p-electrode 32, and pad electrode 33. In this respect, the configuration of semiconductor light-emitting element 300 is the same as that of semiconductor light-emitting element 100.

In semiconductor light-emitting element 300, mesa structure 24 has a polygonal shape in a plan view. More specifically, in semiconductor light-emitting element 300, mesa structure 24 has a regular hexagonal shape in a plan view. In semiconductor light-emitting element 300, first end 24a and second end 24b are both ends of mesa structure 24 in a cross-sectional view orthogonal to second main surface 10b and passing through a pair of opposing corners of mesa structure 24 in a plan view. In semiconductor light-emitting element 300, width W1 is a distance between a pair of opposing corners of mesa structure 24 in a plan view. In semiconductor light-emitting element 300, a plurality of mesa structures 24 are arranged in a regular triangular lattice pattern in a plan view.

In semiconductor light-emitting element 300, protrusion 10c has a polygonal truncated pyramid shape. More specifically, in semiconductor light-emitting element 300, protrusion 10c has a regular hexagonal truncated pyramid shape, top surface 10d has a regular hexagonal shape in a plan view, and the distance between portions of the pair of side surfaces 10e facing each other increases with distance from top surface 10d.

In semiconductor light-emitting element 300, third end 10da and fourth end 10db are both ends of top surface 10d in a cross-sectional view orthogonal to second main surface 10b and passing through a pair of opposing corners of top surface 10d in a plan view. In semiconductor light-emitting element 300, width W2 is a distance between the corners of the pair of top surfaces 10d facing each other in a plan view, and width W3 is a distance between the portions of the pair of side surfaces 10e facing each other at the lower end. In semiconductor light-emitting element 300, a plurality of protrusions 10c are arranged in a regular triangular lattice pattern such that the lower ends of side surfaces 10e are in contact with each other. In semiconductor light-emitting element 300, the center of top surface 10d preferably overlaps with the center of mesa structure 24 in a plan view.

In semiconductor light-emitting element 300, angle θ1 is formed by top surface 10d and an imaginary straight line (see a dotted line in Fig. 27) passing through the center of top surface 10d in a plan view and passing through first end 24a and third end 10da in a cross-sectional view orthogonal to second main surface 10b. In semiconductor light-emitting element 300, the value obtained by dividing height H by width W1 is preferably 0.1 or more, more preferably 0.3 or more, and particularly preferably 0.5 or more and 5 or less. In these respects, the configuration of semiconductor light-emitting element 300 is different from that of semiconductor light-emitting element 100.

### <Method of Manufacturing Semiconductor Light-Emitting Element 300>

The following describes a method of manufacturing semiconductor light-emitting element 300.

The method of manufacturing semiconductor light-emitting element 300 includes preparing step S1, semiconductor layer forming step S2, mesa structure forming step S3, first electrode forming step S4, second electrode forming step S5, substrate back surface processing step S6, mask forming step S7, protrusion forming step S8, and singulating step S9. In this respect, the method of manufacturing semiconductor light-emitting element 300 is the same as the method of manufacturing semiconductor light-emitting element 100.

According to the method of manufacturing semiconductor light-emitting element 300, in mask forming step S7, pattern 51 is formed in a regular hexagonal shape in a plan view, and a plurality of patterns 51 are arranged in a regular triangular lattice pattern in a plan view. In this respect, the method of manufacturing semiconductor light-emitting element 300 is different from the method of manufacturing semiconductor light-emitting element 100.

### <Effects of Semiconductor Light-Emitting Element 300>

The following describes the effects of semiconductor light-emitting element 300.

In semiconductor light-emitting element 300, a plurality of protrusions 10c are formed on second main surface 10b, semiconductor layer 20 has a plurality of mesa structures 24, and each mesa structure 24 and each protrusion 10c face each other. In semiconductor light-emitting element 300, thickness T is 90 µm or less. Thus, also in semiconductor light-emitting element 300, the extraction efficiency for deep ultraviolet light can be improved as in semiconductor light-emitting element 100.

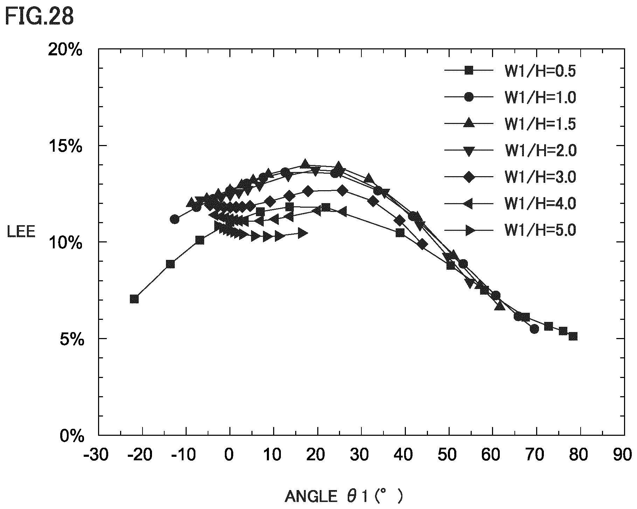

Fig. 28 is a graph showing the relation between angle θ1 and the light extraction efficiency in semiconductor light-emitting element 300. As shown in Fig. 28, in semiconductor light-emitting element 300, the extraction efficiency for deep ultraviolet light is particularly improved in the range in which angle θ1 is -10° or more and 30° or less, and the extraction efficiency for deep ultraviolet light is further improved in the range in which angle θ1 is 0° or more and 20° or less. Based on the above, also in semiconductor light-emitting element 300, angle θ1 is preferably in the range of -10° or more and 30° or less, and more preferably in the range of 0° or more and 20° or less.

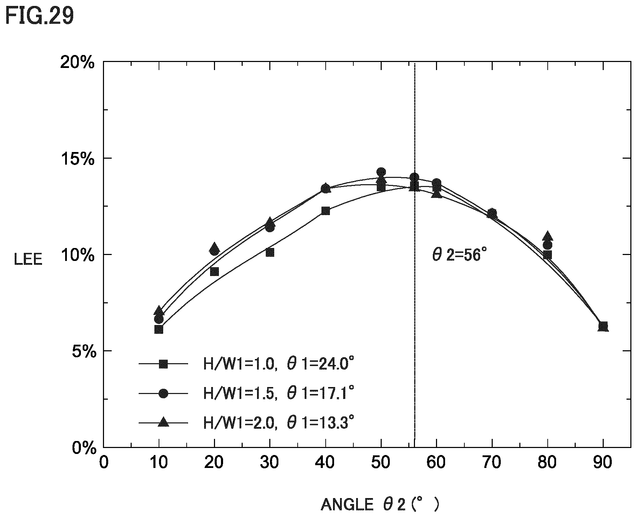

Fig. 29 is a graph showing the relation between angle θ2 and the light extraction efficiency in semiconductor light-emitting element 300. As shown in Fig. 29, in semiconductor light-emitting element 300, the extraction efficiency for deep ultraviolet light becomes maximum when angle θ2 is about 56°. Further, in semiconductor light-emitting element 300, the extraction efficiency for deep ultraviolet light is particularly improved when angle θ2 is 56° ± 10°, and the extraction efficiency for deep ultraviolet light is further improved when angle θ2 is 56° ± 6°. Based on the above, also in semiconductor light-emitting element 300, angle θ2 is preferably in the range of 56° ± 10°, and more preferably in the range of 56° ± 6°. In Figs. 28 and 29, the value obtained by dividing height H by width W1 is changed, angle θ2 is 56°, width W2 is 90 µm, the absorption coefficient of substrate 10 with respect to deep ultraviolet light is 10 cm⁻¹, and thickness T is 10 µm. Fig. 28 shows the relation between angle θ1 and the light extraction efficiency that are calculated using the ray tracing method, and Fig. 29 shows the relation between angle θ2 and the light extraction efficiency that are calculated using the ray tracing method.

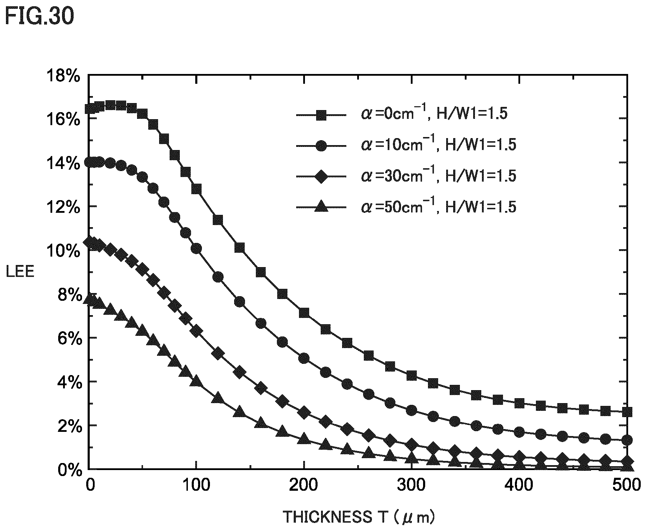

Fig. 30 is a graph showing the relation between thickness T and the light extraction efficiency in semiconductor light-emitting element 300. As shown in Fig. 30, in semiconductor light-emitting element 300, the extraction efficiency for deep ultraviolet light enhances as thickness T decreases. It can be seen from this graph that, even when the constituent material of substrate 10 with respect to deep ultraviolet light has a high absorption coefficient (α), reducing thickness T enables higher extraction efficiency for deep ultraviolet light. Fig. 30 shows the relation between thickness T and the light extraction efficiency that are calculated using the ray tracing method.

### (Fourth Embodiment)

A semiconductor light-emitting element according to the fourth embodiment will be hereinafter described.

The semiconductor light-emitting element according to the fourth embodiment is referred to as a semiconductor light-emitting element 400. In the following, differences from semiconductor light-emitting element 200 will be mainly described, and redundant description will not be repeated.

### <Configuration of Semiconductor Light-Emitting Element 400>

The following describes the configuration of semiconductor light-emitting element 400.

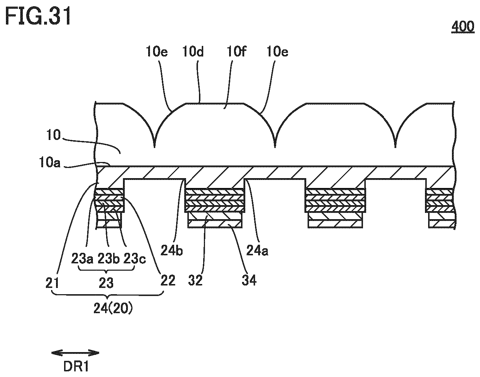

Fig. 31 is a cross-sectional view of semiconductor light-emitting element 400. As shown in Fig. 31, semiconductor light-emitting element 400 includes substrate 10, semiconductor layer 20, n-electrode 31, p-electrode 32, and pad electrode 33. In this respect, the configuration of semiconductor light-emitting element 400 is the same as that of semiconductor light-emitting element 200.

In semiconductor light-emitting element 400, a protrusion 10f is formed as protrusion 10c on second main surface 10b. Protrusion 10f has a convex lens shape. More specifically, in a cross-sectional view, side surface 10e has a curved shape, and the distance between portions of side surface 10e that face each other increases with distance from top surface 10d. Protrusion 10f is preferably inscribed in an outer surface (an imaginary surface) of protrusion 10c in semiconductor light-emitting element 200. The entire surface of protrusion 10f may have a curved shape in a cross-sectional view. In these respects, the configuration of semiconductor light-emitting element 400 is the same as that of semiconductor light-emitting element 200.

### <Method of Manufacturing Semiconductor Light-Emitting Element 400>

The following describes a method of manufacturing semiconductor light-emitting element 400.

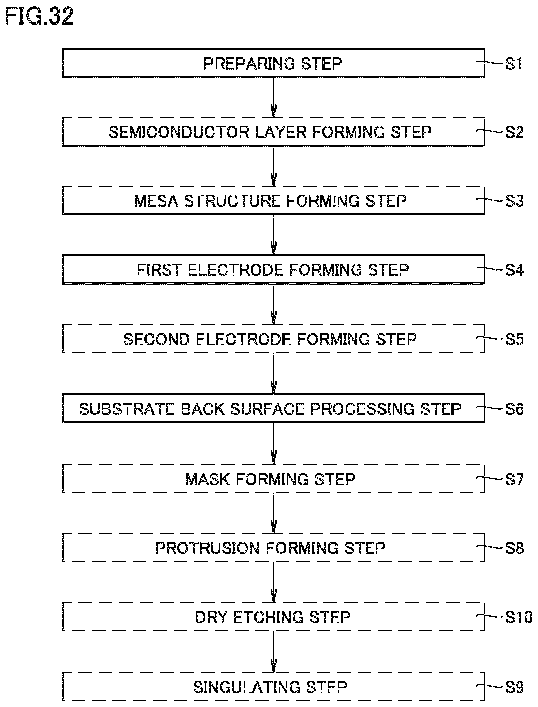

Fig. 32 is a diagram of a process for manufacturing semiconductor light-emitting element 400. As shown in Fig. 32, the method of manufacturing semiconductor light-emitting element 400 includes preparing step S1, semiconductor layer forming step S2, mesa structure forming step S3, first electrode forming step S4, second electrode forming step S5, substrate back surface processing step S6, mask forming step S7, protrusion forming step S8, and singulating step S9. In this respect, the method of manufacturing semiconductor light-emitting element 400 is the same as the method of manufacturing semiconductor light-emitting element 200.

The method of manufacturing semiconductor light-emitting element 400 further includes a dry etching step S10. In dry etching step S10, dry etching is performed to round each corner portion of protrusion 10c, so that protrusion 10c becomes protrusion 10f. In these respects, the method of manufacturing semiconductor light-emitting element 400 is different from the method of manufacturing semiconductor light-emitting element 200.

### <Effects of Semiconductor Light-Emitting Element 400>

The following describes the effects of semiconductor light-emitting element 400.

In semiconductor light-emitting element 400, a plurality of protrusions 10f are formed as the plurality of protrusions 10c on second main surface 10b, semiconductor layer 20 has a plurality of mesa structures 24, and each mesa structure 24 and each protrusion 10f face each other. In semiconductor light-emitting element 300, thickness T is 90 µm or less. Thus, also in semiconductor light-emitting element 300, the extraction efficiency for deep ultraviolet light can be improved as in semiconductor light-emitting element 200.

In semiconductor light-emitting element 400, protrusion 10f has a convex lens shape. Thus, in semiconductor light-emitting element 400, the deep ultraviolet light passes through protrusion 10f and thereby is collimated. Therefore, according to semiconductor light-emitting element 400, the directivity of the deep ultraviolet light can be enhanced.

### (Fifth Embodiment)

A light-emitting module according to the fifth embodiment will be hereinafter described. The light-emitting module according to the fifth embodiment is referred to as a light-emitting module 500.

### <Configuration of Light-Emitting Module 500>

The following describes a configuration of light-emitting module 500.

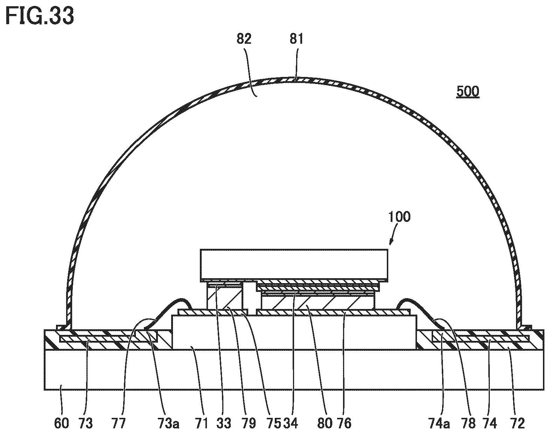

Fig. 33 is a cross-sectional view of light-emitting module 500. As shown in Fig. 33, light-emitting module 500 includes a base 60, a submount 71, an insulating layer 72, wires 73 and 74, connection pads 75 and 76, bonding wires 77 and 78, connection members 79 and 80, a transparent member 81, and a liquid 82.

The constituent material of base 60 is, for example, a metal material, a resin material, a ceramic material, or the like. The constituent material of base 60 preferably has high thermal conductivity. In this case, base 60 functions as a heat sink. Submount 71 is disposed on base 60. The constituent material of submount 71 is preferably a material having high thermal conductivity, such as aluminum nitride, silicon, silicon carbide (SiC), diamond, or the like.

Insulating layer 72 is disposed on base 60 so as to surround the outer periphery of submount 71. Wires 73 and 74 are embedded, for example, in insulating layer 72. Wire 73 has one end provided with a pad 73a and the other end through which it receives power from the outside. Wire 74 has one end provided with a pad 74a and the other end through which it receives power from the outside. Pads 73a and 74a are exposed from insulating layer 72.

Connection pads 75 and 76 are disposed on submount 71. Bonding wire 77 has one end connected to pad 73a and the other end connected to connection pad 75. Bonding wire 78 has one end connected to pad 74a and the other end connected to connection pad 76. Connection pad 75 is connected to pad electrode 33 by connection member 79. Connection pad 76 is connected to pad electrode 34 by connection member 80. The constituent material of each of connection members 79 and 80 is, for example, a gold-tin alloy. In this way, pad electrode 33 is electrically connected to wire 73 via connection member 79 and bonding wire 77, and pad electrode 34 is electrically connected to wire 74 via connection member 80 and bonding wire 78, with the result that deep ultraviolet light is generated from active layer 22 based on the current applied between the other end of wire 73 and the other end of wire 74.

Transparent member 81 has, for example, a hemispherical shape that is increased in diameter from one end toward the other end and that is open at the other end. The other end of transparent member 81 is connected onto insulating layer 72, for example, with an adhesive. Transparent member 81 is transparent to deep ultraviolet light generated from active layer 22. Transparent member 81 has a transmittance, for example, of 60 percent or more with respect to the deep ultraviolet light generated from active layer 22. The constituent material of transparent member 81 is, for example, an inorganic material or a resin material. Specific examples of the inorganic material include synthetic quartz, quartz glass, alkali-free glass, sapphire, fluorite (CaF), and the like. Specific examples of the resin material include a silicone resin having no aromatic ring, an amorphous fluorine-containing resin, polyimide, an epoxy resin, and the like. The resin material may contain an inorganic material.

Semiconductor light-emitting element 100 is disposed inside transparent member 81. Although not shown, semiconductor light-emitting element 200, 300, or 400 may be used in place of semiconductor light-emitting element 100. Liquid 82 fills the inside of transparent member 81. Thus, semiconductor light-emitting element 100 is sealed with liquid 82. Liquid 82 is transparent to the deep ultraviolet light generated from active layer 22. Liquid 82 has a transmittance, for example, of 60 percent or more with respect to the deep ultraviolet light generated from active layer 22. Liquid 82 is, for example, pure water, a liquid organic compound, a salt solution, a solution containing dispersed particles, or the like. The refractive index of liquid 82 is greater than 1. The refractive index of liquid 82 is preferably 1.5 or more.

### <Method of Manufacturing Light-Emitting Module 500>

The following describes a method of manufacturing light-emitting module 500.

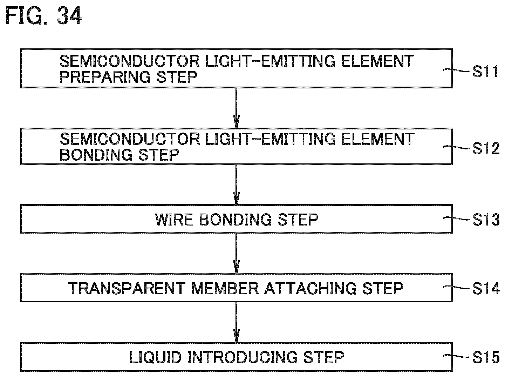

Fig. 34 is a diagram of a process for manufacturing light-emitting module 500. As shown in Fig. 34, the method of manufacturing light-emitting module 500 includes a semiconductor light-emitting element preparing step S11, a semiconductor light-emitting element bonding step S12, a wire bonding step S13, a transparent member attaching step S14, and a liquid introducing step S15.

In the method of manufacturing light-emitting module 500, first, semiconductor light-emitting element preparing step S11 is performed. In semiconductor light-emitting element preparing step S11, semiconductor light-emitting element 100 is prepared by performing preparing step S1 to singulating step S9. In semiconductor light-emitting element bonding step S12, pad electrode 33 is connected to connection pad 75 by connection member 79, and pad electrode 34 is connected to connection pad 76 by connection member 80.

Wire bonding step S13 is performed after semiconductor light-emitting element bonding step S12. In wire bonding step S13, bonding wire 77 is connected to pad 73a and connection pad 75, and bonding wire 78 is connected to pad 74a and connection pad 76. Transparent member attaching step S14 is performed after wire bonding step S13. In transparent member attaching step S14, transparent member 81 is attached to insulating layer 72 with an adhesive or the like. Liquid introducing step S15 is performed after transparent member attaching step S14. In liquid introducing step S15, liquid 82 is introduced into transparent member 81, and semiconductor light-emitting element 100 is sealed with liquid 82. Thereby, light-emitting module 500 having the structure shown in Fig. 33 is formed.

### <Modification>

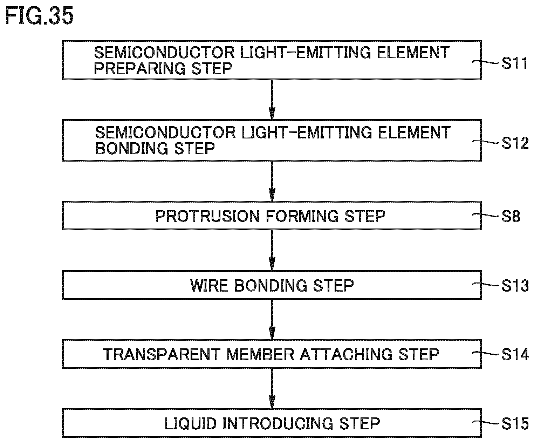

Fig. 35 is a diagram of a process for manufacturing light-emitting module 500 according to a modification. As shown in Fig. 35, in the method of manufacturing light-emitting module 500, protrusion forming step S8 may not be performed in semiconductor light-emitting element preparing step S11, but protrusion forming step S8 may be performed after semiconductor light-emitting element bonding step S12 is performed and before wire bonding step S13 is performed. Thereby, since semiconductor light-emitting element 100 can be mounted on submount 71 in the state in which substrate 10 is thick, damage to semiconductor light-emitting element 100 (for example, cracking of substrate 10) in semiconductor light-emitting element bonding step S12 can be suppressed.

### <Effects of Light-Emitting Module 500>

The following describes the effects of light-emitting module 500.

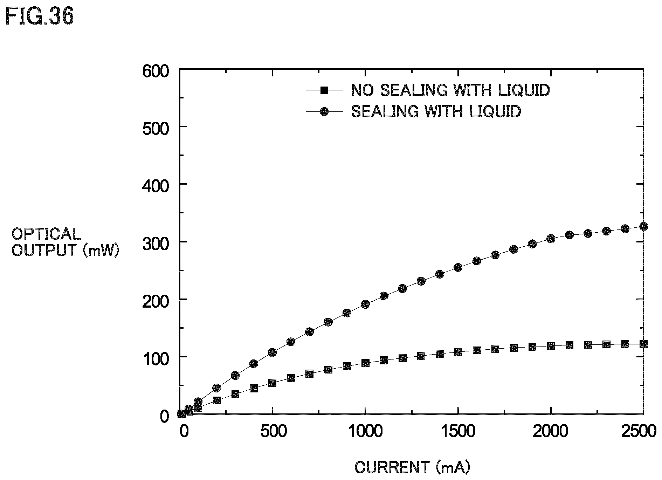

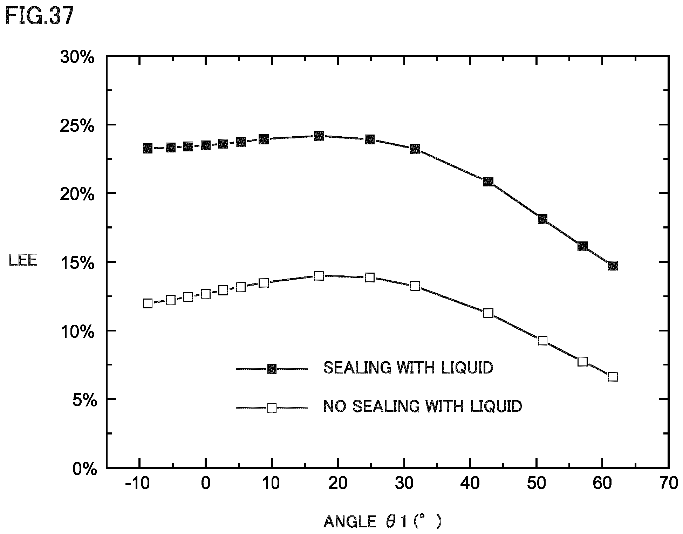

Fig. 36 is a graph showing the relation between a current and an output of deep ultraviolet light in light-emitting module 500. Fig. 37 is a graph showing the relation between the current and the extraction efficiency for deep ultraviolet light in light-emitting module 500. In Fig. 36, semiconductor light-emitting element 100 is used for light-emitting module 500. In Fig. 37, semiconductor light-emitting element 300 is used for light-emitting module 500. In Fig. 37, the refractive index of liquid 82 is 1.54, width W2 is 90 µm, thickness T is 10 µm, angle θ2 is, and the value obtained by dividing height H by width W1 is 1.5. Figs. 36 and 37 each show experimental values of the relation between the current and the optical output or the external quantum efficiency.

As shown in Fig. 36, in light-emitting module 500, the inside of transparent member 81 is filled with liquid 82, and thereby, the optical output of the deep ultraviolet light is improved. More specifically, the inside of transparent member 81 is filled with liquid 82, and thereby, the optical output occurring when a current of 1000 mA flows is 2.15 times larger, and the optical output occurring when a current of 2000 mA flows is 2.57 times larger.

As shown in Fig. 37, in light-emitting module 500, the inside of transparent member 81 is filled with liquid 82, and thereby, the extraction efficiency for deep ultraviolet light is improved. More specifically, the inside of transparent member 81 is filled with liquid 82, and thereby, the light extraction efficiency at angle θ1 of -10° is 1.94 times higher, the optical output at angle θ1 of 25° is 1.72 times larger, and the light extraction efficiency at angle θ1 of 60° is 2.21 times higher. From this comparison, in light-emitting module 500, filling the inside of transparent member 81 with liquid 82 enables improvement in extraction efficiency for deep ultraviolet light.

Although the embodiments of the present disclosure have been described above, the above-described embodiments may be variously modifiable. Further, the scope of the present invention is not limited to the above-described embodiments. The scope of the present invention is defined by the terms of the claims, and is intended to include any modifications within the scope and meaning equivalent to the terms of the claims.

### REFERENCE SIGNS LIST

10 substrate, 10a first main surface, 10b second main surface, 10c, 10f protrusion, 10d top surface, 10da third end, 10db fourth end, 10e side surface, 10ea first side surface, 10eb second side surface, 20 semiconductor layer, 21 n-type semiconductor layer, 22 active layer, 23 p-type semiconductor layer, 23a electron blocking layer, 23b cladding layer, 23c contact layer, 24 mesa structure, 24a first end, 24b second end, 31, 32 electrode, 33, 34 pad electrode, 40 anti-reflection film, 50 mask, 51 pattern, 52 opening, 60 base, 71 submount, 72 insulating layer, 73, 74 wire, 73a, 74a pad, 75, 76 connection pad, 77, 78 bonding wire, 79, 80 connection member, 81 transparent member, 82 liquid, 100, 100A, 200, 200A, 300, 400 semiconductor light-emitting element, 500 light-emitting module, DR1 first direction, DR2 second direction, H height, T thickness, W1, W2, W3 width, S1 preparing step, S2 semiconductor layer forming step, S3 mesa structure forming step, S4 first electrode forming step, S5 second electrode forming step, S6 substrate back surface processing step, S7 mask forming step, S8 protrusion forming step, S9 singulating step, S10 dry etching step, S11 semiconductor light-emitting element preparing step, S12 semiconductor light-emitting element bonding step, S13 wire bonding step, S14 transparent member attaching step, S15 liquid introducing step.

## Claims

1. A semiconductor light-emitting element comprising:
a substrate; and
a semiconductor layer, wherein
a constituent material of the substrate is single-crystalline aluminum nitride,
the substrate has a first main surface and a second main surface opposite to the first main surface,
the semiconductor layer has
an n-type semiconductor layer disposed on the first main surface,
an active layer disposed on the n-type semiconductor layer to generate deep ultraviolet light, and
a p-type semiconductor layer disposed on the active layer,
the semiconductor layer has a plurality of mesa structures in one of cross-sectional views,
a plurality of protrusions are formed on the second main surface,
each of the protrusions faces each of the mesa structures,
each of the protrusions has a top surface, and
an angle defined by tan⁻¹{(W2-W1)/2L} is -25° or more and 65° or less, where W1 is a width of each of the mesa structures, W2 is a width of the top surface, and L is a distance between the active layer and the top surface.

2. The semiconductor light-emitting element according to claim 1,
wherein a thickness of the substrate between adjacent two of the protrusions is 90 µm or less.

3. The semiconductor light-emitting element according to claim 1, wherein
each of the mesa structures extends in a first direction in a plan view,
each of the protrusions extends in the first direction in a state in which each of the protrusions faces each of the mesa structures in a plan view,
each of the protrusions further has a first side surface and a second side surface that are contiguous to the top surface, the first side surface and the second side surface facing each other in a second direction orthogonal to the first direction, and
a distance between the first side surface and the second side surface increases with distance from the top surface.

4. The semiconductor light-emitting element according to claim 3,
wherein a lower end of the first side surface of one of adj acent two of the protrusions is contiguous to a lower end of the second side surface of the other of the adjacent two of the protrusions.

5. The semiconductor light-emitting element according to claim 3,
wherein each of an angle formed by the first side surface and a surface parallel to the top surface and an angle formed by the second side surface and a surface parallel to the top surface is 56° ± 20°.

6. The semiconductor light-emitting element according to claim 3,
wherein a value obtained by dividing a height of each of the protrusions by a width of each of the mesa structures in the second direction is 0.5 or more and 3 or less.

7. The semiconductor light-emitting element according to claim 1, further comprising an anti-reflection film disposed on the top surface.

8. The semiconductor light-emitting element according to claim 1, wherein
each of the protrusions further has a side surface contiguous to the top surface,
the mesa structures and the top surface are circular in a plan view,
the side surface forms a conical surface, and
a diameter of the side surface increases with distance from the top surface.

9. The semiconductor light-emitting element according to claim 8, wherein a lower end of the side surface of one of adjacent two of the protrusions is contiguous to a lower end of the side surface of the other of the adjacent two of the protrusions.

10. The semiconductor light-emitting element according to claim 8, wherein an angle formed by the side surface and a surface parallel to the top surface is 56° ± 20°.

11. The semiconductor light-emitting element according to claim 8, wherein, in a cross-sectional view orthogonal to the first main surface and passing through a center of each of the mesa structures in a plan view, a value obtained by dividing a height of each of the protrusions by the width of each of the mesa structures is 0.5 or more and 5 or less.

12. The semiconductor light-emitting element according to claim 1, wherein
each of the protrusions further has a side surface contiguous to the top surface,
the side surface has a curved shape in a cross-sectional view, and
a distance between portions of the side surface that face each other in a cross-sectional view increases with distance from the top surface.

13. The semiconductor light-emitting element according to claim 12, wherein a thickness of the substrate between adjacent two of the protrusions is 90 µm or less.

14. A light-emitting module comprising:
the semiconductor light-emitting element according to any one of claims 1 to 13;
a transparent member; and
a liquid, wherein
the semiconductor light-emitting element is disposed inside the transparent member,
the liquid fills an inside of the transparent member to seal the semiconductor light-emitting element, and
the transparent member and the liquid are transparent to the deep ultraviolet light.

15. A method of manufacturing a semiconductor light-emitting element, the method comprising:
preparing a substrate having a first main surface and a second main surface opposite to the first main surface;
forming a semiconductor layer on the first main surface; and
forming a plurality of protrusions on the second main surface, wherein
a constituent material of the substrate is single-crystalline aluminum nitride,
the second main surface is a nitrogen polar plane of aluminum nitride,
the semiconductor layer has
an n-type semiconductor layer disposed on the first main surface,
an active layer disposed on the n-type semiconductor layer to generate deep ultraviolet light, and
a p-type semiconductor layer disposed on the active layer,
the semiconductor layer has a plurality of mesa structures in one of cross-sectional views, and
the forming a plurality of protrusions on the second main surface includes
forming a mask on a portion of the second main surface that faces each of the mesa structures, and
wet etching the substrate exposed from the mask.

16. The method of manufacturing a semiconductor light-emitting element according to claim 15, wherein
each of the mesa structures extends in a straight line shape in a plan view, and
the mask has a pattern extending in a straight line shape in a state in which the mask faces each of the mesa structures in a plan view.

17. The method of manufacturing a semiconductor light-emitting element according to claim 15, wherein the mesa structures and the mask are circular in a plan view.

18. The method of manufacturing a semiconductor light-emitting element according to claim 15, wherein the wet etching proceeds such that a sidewall surface of a recess formed in the second main surface by the wet etching forms an angle of 56° ± 6° with a surface parallel to a portion of the second main surface, the portion of the second main surface being located below the mask.

19. The method of manufacturing a semiconductor light-emitting element according to claim 15, wherein the wet etching stops when a lower end of a first sidewall surface of a recess formed in the second main surface by the wet etching comes into contact with a lower end of a second sidewall surface of the recess, the second sidewall surface facing the first sidewall surface with a space being interposed therebetween.

20. The method of manufacturing a semiconductor light-emitting element according to claim 15, wherein an etching solution used in the wet etching is a hot alkaline solution.

21. The method of manufacturing a semiconductor light-emitting element according to claim 15, wherein the mask remains as an anti-reflection film after the wet etching.

22. The method of manufacturing a semiconductor light-emitting element according to any one of claims 15 to 20, further comprising dry etching the protrusions, wherein
the dry etching is performed such that each of the protrusions has a convex lens shape.

23. A method of manufacturing a light-emitting module, the method comprising:
preparing a semiconductor light-emitting element; and
mounting the semiconductor light-emitting element on a submount, wherein
the preparing a semiconductor light-emitting element includes
preparing a substrate having a first main surface and a second main surface opposite to the first main surface,
forming a semiconductor layer on the first main surface, and
forming a plurality of protrusions on the second main surface,
a constituent material of the substrate is single-crystalline aluminum nitride,
the second main surface is a nitrogen polar plane of aluminum nitride,
the semiconductor layer has
an n-type semiconductor layer disposed on the first main surface,
an active layer disposed on the n-type semiconductor layer to generate deep ultraviolet light, and
a p-type semiconductor layer disposed on the active layer,
the semiconductor layer has a plurality of mesa structures,
the forming a plurality of protrusions on the second main surface includes
forming a mask on a portion of the second main surface that faces each of the mesa structures, and
wet etching the substrate exposed from the mask, and
the wet etching is performed after the mounting the semiconductor light-emitting element on a submount.
